# EUROPEAN PATENT APPLICATION

(11) **EP 4 472 388 A1**
(43) Date of publication of application: **04.12.2024**
(21) Application number: 22924184.9
(22) Date of filing: 22.12.2022
(51) Int. Cl.: H10N 10/852, B22F 3/105, B22F 3/14, C22C 28/00, C22F 1/00, C22F 1/18, H10N 10/01

(54) **THERMOELECTRIC CONVERSION MATERIAL, THERMOELECTRIC CONVERSION MATERIAL COMPOSITION, THERMOELECTRIC CONVERSION ELEMENT, THERMOELECTRIC CONVERSION MODULE, THERMOELECTRIC CONVERSION SYSTEM, METHOD FOR PRODUCING THERMOELECTRIC CONVERSION MATERIAL COMPOSITION, AND METHOD FOR PRODUCING THERMOELECTRIC CONVERSION MATERIAL**

(30) Priority: 28.01.2022 JP 2022012174; 04.08.2022 JP 2022125040
(71) Applicant: Panasonic Intellectual Property Management Co., Ltd., Kadoma-shi, Osaka 571-0057 (JP)
(72) Inventor: ANDO Fuyuki, Kadoma-shi, Osaka 571-0057 (JP); TAMAKI Hiromasa, Kadoma-shi, Osaka 571-0057 (JP); YAMAMURA Ryosuke, Kadoma-shi, Osaka 571-0057 (JP)
(74) Representative: Eisenführ Speiser
(86) International application number: PCT/JP2022/047476
(87) International publication number: WO 2023/145337

(57) **Abstract**

A thermoelectric conversion material according to the present disclosure includes Ge, In, Ti, and at least one selected from the group consisting of Sb and Bi, and Te, and satisfies a requirement (1): a + β + γ ≤ 0.98. In the requirement (1), a is a molar ratio of a content of Ge to a content of Te, β is a molar ratio of a sum of a content of In and a content of Ti to the content of Te, and γ is a molar ratio of a sum of a content of Sb and a content of Bi to the content of Te.

## Description

### TECHNICAL FIELD

The present invention relates to a thermoelectric conversion material, a composition for a thermoelectric conversion material, a thermoelectric conversion element, a thermoelectric conversion module, a thermoelectric conversion system, a method of manufacturing a composition for a thermoelectric conversion material, and a method of manufacturing a thermoelectric conversion material.

### BACKGROUND ART

Thermoelectric conversion materials including Ge and Te have been known.

For example, Non Patent Literature 1 describes a thermoelectric conversion material represented by Ge_{1-x-y}SbₓIn_{y}Te, where x is from 0 to 0.12 and y is from 0 to 0.012, and a method of manufacturing the same.

Non Patent Literature 2 describes a thermoelectric conversion material represented by Ge_{1-x-y}TiₓSb_{y}Te, where x is from 0 to 0.03 and y is 0 to 0.08, and a method of manufacturing the same.

Non Patent Literature 3 describes a thermoelectric conversion material represented by (Ge_{0.96-x}In_{0.01}Ti_{0.03}SbₓTe)_{0.99}-(Cu₂Te)_{0.01}, where x is 0.04, 0.06, or 0.08, and a method of manufacturing the same.

### CITATION LIST

### Patent Literature

### Non Patent Literature

Non Patent Literature 1: M. Hong et al., "Realizing zT of 2.3 in Ge1-x-ySbxlnyTe via Reducing the Phase-Transition Temperature and Introducing Resonant Energy Doping", Advanced Materials, Vol. 30, Issue 1705942 (2018) [DOI: 10.1002/adma.201705942]
Non Patent Literature 2: M. Li et al., "Crystal symmetry induced structure and bonding manipulation boosting thermoelectric performance of GeTe", Nano Energy, Vol. 73, Issue 104740 (2020) [DOI: 10.1016/j.nanoen.2020.104740]
Non Patent Literature 3: Jing Cao et al.,"Realizing zT Values of 2.0 in Cubic GeTe", ChemNanoMat, Vol. 7,pp.1-8,(2021)[DOI: 10.1002/cnma.202100033]

### SUMMARY OF INVENTION

### Technical Problem

The present disclosure provides a thermoelectric conversion material that is advantageous from the viewpoint of thermoelectric conversion performance and toughness.

### Solution to Problem

The thermoelectric conversion material of the present disclosure includes: Ge, In, Ti, at least one selected from the group consisting of Sb and Bi, and Te,
wherein the thermoelectric conversion material satisfies a requirement (1): a + β + γ ≤ 0.98,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

### Advantageous Effects of Invention

According to the present disclosure, a thermoelectric conversion material that is advantageous from the viewpoint of thermoelectric conversion performance and toughness can be provided.

### BRIEF DESCRIPTION OF DRAWINGS

FIG. 1 is a schematic diagram of a NaCl-type crystal structure.
FIG. 2A is a schematic diagram showing an example of a thermoelectric conversion element of the present disclosure.
FIG. 2B is a schematic diagram showing an example of a thermoelectric conversion module of the present disclosure.
FIG. 2C is a perspective view showing another example of a thermoelectric conversion module of the present disclosure.
FIG. 2D is a schematic diagram showing an example of a thermoelectric conversion system of the present disclosure.
FIG. 3A is a diagram schematically showing a three-point bending test.
FIG. 3B is a graph showing a relationship between "a breaking stress of a thermoelectric conversion material according to each Example and each Comparative Example determined from a result of three-point bending test" and "mole ratio (Ge + In + Ti + Sb)/Te in each thermoelectric conversion material".
FIG. 4A is a graph showing a result of X-ray diffraction analysis of a thermoelectric conversion material according to Comparative Example 1.
FIG. 4B is a graph showing a result of X-ray diffraction analysis of a thermoelectric conversion material according to Example 3.
FIG. 4C is a graph showing a simulation result of an X-ray diffraction pattern of GeTe with a crystal structure represented by a space group Fm-3m and an X-ray diffraction pattern of GeTe with a crystal structure represented by a space group R-3m.
FIG. 5A is a graph showing a relationship between temperature and lattice thermal conductivities of thermoelectric conversion materials.
FIG. 5B is a graph showing a relationship between temperature and figures of merits of thermoelectric conversion materials according to the respective Examples and Comparative Example 1.

### DESCRIPTION OF EMBODIMENTS

### (Findings that forms the basis of the present disclosure)

In a case of manufacturing a thermoelectric conversion element using a thermoelectric conversion material, a plurality of thermoelectric conversion materials may be produced from a single sintered body. For example, a plurality of thermoelectric conversion materials can be produced by cutting a sintered body.

Non Patent Literatures 1, 2, and 3 describe methods of manufacturing predetermined thermoelectric conversion materials including Ge and Te, and thermoelectric conversion performance thereof. It is understood that these thermoelectric conversion materials can exhibit predetermined thermoelectric conversion performance. Meanwhile, according to studies by the present inventors, since a thermoelectric conversion material including Ge and Te is brittle, it is difficult to produce a thermoelectric conversion element using the thermoelectric conversion material to manufacture a thermoelectric conversion module. Therefore, the present inventors conducted extensive research to see if it is possible to develop a thermoelectric conversion material that is advantageous in the production of thermoelectric conversion elements from the viewpoint of thermoelectric conversion performance and toughness. As a result, the inventors concluded that a grain boundary segregation of a simple substance of Ge is the cause of the brittleness of the thermoelectric conversion material including Ge and Te. And the present inventors found that a grain boundary segregation of a simple substance of Ge can be easily prevented/reduced by adding not only Ge and Te but also In, Ti, and at least one selected from the group consisting of Sb and Bi, to the thermoelectric conversion material and by adjusting the contents of the respective elements to a predetermined ratio. As a result, it was found that the toughness of the thermoelectric conversion material is increased. A further finding is that in a thermoelectric conversion material, the lattice thermal conductivity, which is the thermal conductivity related to heat conduction accompanying vibration of the lattice, is reduced, making it easier to exhibit desired thermoelectric conversion performance. Based on these new findings, the present inventors have completed the thermoelectric conversion material according to the present disclosure.

### (Embodiment of the present disclosure)

Hereinafter, embodiments of the present disclosure will be explained with reference to the attached drawings.

The thermoelectric conversion material of the present disclosure includes Ge, In, Ti, at least one selected from the group consisting of Sb and Bi, and Te. The thermoelectric conversion material satisfies a requirement (1): a + β + γ ≤ 0.98. In the requirement (1), a is a molar ratio of a content of Ge to a content of Te. β is a molar ratio of a sum of a content of In and a content of Ti to the content of Te. γ is a molar ratio of a sum of a content of Sb and a content of Bi to the content of Te. The contents of Ge, In, Ti, Sb, Bi, and Te in the thermoelectric conversion material can be determined, for example, by SEM-EDX and inductively coupled plasma (ICP) emission spectroscopy, where the SEM-EDX is a combination of scanning electron microscopy (SEM) and energy dispersive X-ray spectroscopy (EDX). It should be noted that the requirements based on the contents of Ge, In, Ti, Sb, Bi, and Te are assumed to hold in a case where it holds for both the contents determined according to the SEM-EDX and the contents based on the ICP emission spectrometry.

The thermoelectric conversion material includes not only Ge and Te, but also In, Ti, and at least one selected from the group consisting of Sb and Bi, so that it is more likely to exhibit desired thermoelectric conversion performance. In addition, in the thermoelectric conversion material satisfying the requirement (1), a grain boundary segregation of a simple substance of Ge may be easily prevented or reduced. For this reason, the thermoelectric conversion material may easily have a desired toughness and can be cut easily. Additionally, the sintered body included in the thermoelectric conversion material is less likely to crack. Therefore, use of the thermoelectric conversion material tends to increase the yield of a thermoelectric conversion element and furthermore, the yield of a thermoelectric conversion module. In addition, use of the thermoelectric conversion element and furthermore use of the thermoelectric conversion module can easily prevent cracks in the sintered body including the thermoelectric conversion material, where the cracks may be caused by a stress such as a thermal stress. As a result, durability of the thermoelectric conversion element and the thermoelectric conversion module can be easily improved.

The thermoelectric conversion material may satisfy a requirement a + β + γ ≤ 0.97, or it may satisfy a requirement a + β + γ ≤ 0.96.

The thermoelectric conversion material, for example, satisfies a requirement (2): β + γ < a. Thereby, the thermoelectric conversion material is more likely to exhibit desired thermoelectric conversion performance and more likely to have desired toughness.

As to the thermoelectric conversion material, a - (β + γ) is not limited to a specific value. The thermoelectric conversion material, for example, satisfies a requirement 0.35 ≤ a - (β + γ) < 0.98. In this case, the thermoelectric conversion material is more likely to exhibit desired thermoelectric conversion performance and more likely to have desired toughness.

The thermoelectric conversion material satisfies, for example, a requirement (3): a + β + γ ≥ 0.85. Thereby, the thermoelectric conversion material is more likely to exhibit desired thermoelectric conversion performance and more likely to have desired toughness.

The thermoelectric conversion material may satisfy a requirement a + β + γ ≥ 0.86, or it may satisfy a requirement a + β + γ ≥ 0.87.

The thermoelectric conversion material has, for example, a constitution represented by Ge_{α}InₓTi_{β-x}Sb_{y}Bi_{γ-y}Te. In this constitution, requirements 0.65 ≤ a < 0.98, 0 < β ≤ 0.1, 0 < x < β, 0 < γ ≤ 0.2, and 0 ≤ y ≤ γ are satisfied. Thereby, the thermoelectric conversion material is more likely to exhibit desired thermoelectric conversion performance and more likely to have desired toughness.

In the constitution, a requirement a ≥ 0.66 may be satisfied, a requirement a ≥ 0.67 may be satisfied, a requirement a ≥ 0.69 may be satisfied, a requirement a ≥ 0.70 may be satisfied, or a requirement a ≥ 0.72 may be satisfied. In the constitution, a requirement a ≤ 0.97 may be satisfied, a requirement a ≤ 0.95 may be satisfied, or a requirement a ≤ 0.93 may be satisfied. In the constitution, a requirement a ≤ 0.90 may be satisfied, a requirement a ≤ 0.87 may be satisfied, or a requirement a ≤ 0.84 may be satisfied.

In the constitution, a requirement β ≥ 0.001 may be satisfied, a requirement β ≥ 0.002 may be satisfied, a requirement β ≥ 0.003 may be satisfied, a requirement β ≥ 0.004 may be satisfied, or a requirement β ≥ 0.005 may be satisfied. In the constitution, a requirement β ≤ 0.09 may be satisfied, a requirement β ≤ 0.08 may be satisfied, a requirement β ≤ 0.07 may be satisfied, a requirement β ≤ 0.06 may be satisfied, or a requirement β ≤ 0.05 may be satisfied. The constitution satisfies, for example, a requirement 0.001 ≤ β ≤ 0.04. Thereby, the thermoelectric conversion material is more likely to exhibit desired thermoelectric conversion performance and more likely to have desired toughness.

In the constitution, a requirement γ ≥ 0.01 may be satisfied, a requirement γ ≥ 0.02 may be satisfied, a requirement γ ≥ 0.03 may be satisfied, or a requirement γ ≥ 0.04 may be satisfied. In the constitution, a requirement γ ≤ 0.19 may be satisfied, a requirement γ ≤ 0.18 may be satisfied, or a requirement γ ≤ 0.17 may be satisfied. The constitution satisfies, for example, a requirement 0.04 ≤ y < 0.16. Thereby, the thermoelectric conversion material is more likely to exhibit desired thermoelectric conversion performance and more likely to have desired toughness.

The crystal structure of the thermoelectric conversion material is not limited to a specific crystal structure. The thermoelectric conversion material has, for example, a NaCl-type crystal structure. In this case, the thermoelectric conversion material is more likely to exhibit desired thermoelectric conversion performance and more likely to have desired toughness. The thermoelectric conversion material may have a crystal structure belonging to at least one selected from the group consisting of a space group Fm-3m and a space group R-3m. Similarly in this case, the thermoelectric conversion material is more likely to exhibit desired thermoelectric conversion performance and more likely to have desired toughness.

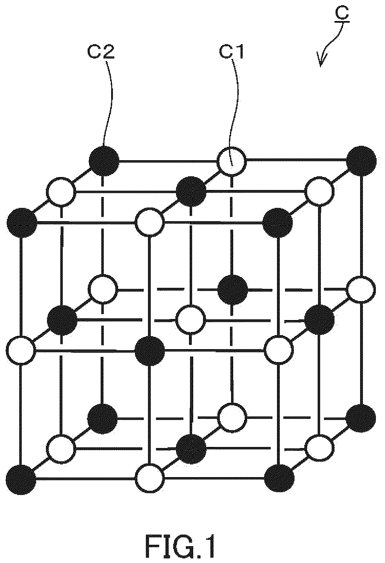

FIG. 1 schematically shows a NaCl-type crystal structure C. In FIG. 1, C1 indicates a Na site and C2 indicates a Cl site. In a case where the thermoelectric conversion material has a NaCl-type crystal structure, Ge, In, Ti, Sb, and Bi can be arranged at the Na site, and Te can be arranged at the Cl site. Thereby, the thermoelectric conversion material is more likely to exhibit desired thermoelectric conversion performance and more likely to have desired toughness. It should be noted that in the thermoelectric conversion material, not all sites in the crystal structure need to be filled, and lattice defects such as vacancies may be present in the crystal structure.

A thermoelectric conversion material is, for example, a polycrystal including a plurality of crystal grains. Each of the crystal grains has, for example, a NaCl-type crystal structure. Thereby, the thermoelectric conversion material is more likely to exhibit desired thermoelectric conversion performance and more likely to have desired toughness. For example, the crystal structure of the crystal grains can be confirmed by analyzing the thermoelectric conversion material in accordance with the X-ray diffraction method.

The thermoelectric conversion material has breaking stress BS that is not limited to a specific value. In the thermoelectric conversion material, for example, a requirement (4): 30 N/mm² ≤ BS ≤ 5000 N/mm² is satisfied. In the requirement (4), BS indicates the breaking stress BS of the thermoelectric conversion material. The breaking stress BS of the thermoelectric conversion material can be determined, for example, by a three-point bending test. The three-point bending test is performed using a test piece that is prepared from a thermoelectric conversion material for the three-point bending test. The breaking stress of the thermoelectric conversion material can be determined by dividing the breaking load of the test piece in this test by the area of the fracture surface of the test piece. The shape and dimensions of the test piece can be determined from the viewpoint of the area of the fracture surface, the distance between fulcrums, and easiness in calculation of the point of effort. The test piece is rectangular parallelepiped, for example. The three-point bending test is preferably performed with two or more test pieces for each thermoelectric conversion material. The three-point bending test, more desirably, is performed with four or more test pieces. The three-point bending test is performed at 25°C, for example. For example, a three-point bending test can be performed by a testing machine conforming to Japanese Industrial Standard JIS B7721 Class 1, ISO 7500-1 Class 1, EN10002-2 Grade 1, or ASTM E4.

A thermoelectric conversion material satisfying the requirement (4) has a high toughness, for example, and thus, a sintered body including the thermoelectric conversion material is easy to cut. The thermoelectric conversion material preferably may satisfy a requirement BS ≥ 35 N/mm², or may satisfy a requirement BS ≥ 40 N/mm². The thermoelectric conversion material may satisfy a requirement BS ≤ 4000 N/mm², a requirement BS ≤ 3000 N/mm², a requirement BS ≤ 2000 N/mm², or a requirement BS ≤ 1000 N/mm². The thermoelectric conversion material may satisfy a requirement BS ≤ 500 N/mm².

Methods of manufacturing the thermoelectric conversion material are not limited to any particular method.

In a method of manufacturing the thermoelectric conversion material, for example, an alloy powder is energized by a spark plasma sintering (SPS) method so as to sinter the alloy powder at a temperature of 500°C or higher, where the alloy powder includes Ge, In, Ti, at least one selected from the group consisting of Sb and Bi, and Te. The alloy powder is, for example, a polycrystalline powder. In the SPS, the alloy powder is filled into a die made of carbon, for example. In sintering, a predetermined pressure is applied to the alloy powder. The pressure is from 10 MPa to 100 MPa, for example. After the sintering, the pressure is gradually reduced. The temperature for sintering the alloy powder is, for example, lower than the melting temperature of the alloy, or for example, 700°C or lower. The time required to energize the alloy powder in the sintering is not limited to a particular value. The energization time, for example, is from 2 minutes to 1 hour.

The alloy powder is obtained by pulverizing, for example, a composition for a thermoelectric conversion material. The composition for a thermoelectric conversion material is manufactured, for example, by a process including the following steps (I), (II), and (III). The composition for a thermoelectric conversion material can satisfy a requirement (6): a + β + γ ≤ 1.0.
(I) Heating a mixture including Ge, In, Ti, at least one selected from the group consisting of Sb and Bi, and Te, at a temperature of 700°C or higher to obtain a melt
(II) Quenching the melt obtained in the step (I) with a liquid having a temperature of 100°C or lower to obtain a solidified body
(III) Heating the solidified body obtained in the step (II) at a temperature of 400°C or higher to obtain a polycrystal

The composition for a thermoelectric conversion material may satisfy a requirement a + β + γ ≤ 0.99, may satisfy a requirement a + β + γ ≤ 0.97, may satisfy a requirement a + β + γ ≤ 0.96, or may satisfy a requirement a + β + γ ≤ 0.95. The composition for a thermoelectric conversion material may satisfy a requirement a + β + γ ≥ 0.83, or may satisfy a requirement a + β + γ ≥ 0.84. The composition for a thermoelectric conversion material may satisfy a requirement β + γ < a. The composition for a thermoelectric conversion material satisfies a requirement, for example, 0.35 ≤ a - (β + γ) < 1.0.

In the step (I), for example, in an inert gas atmosphere, Ge, In, Ti, at least one selected from the group consisting of Sb and Bi, and Te are weighed and introduced into a quartz tube. Next, the interior of the quartz tube is vacuumed and the tube is sealed. The sealed quartz tube is heated at a predetermined temperature for a predetermined time to obtain a melt. The temperature for heating the mixture is, for example, 1200°C or lower.

In the step (II), for example, the quartz tube is placed in water with the melt present inside the quartz tube, so that the melt is quenched, whereby a solidified body is obtained.

In the step (III), the temperature for heating the solidified body is adjusted to a temperature of 400°C or higher at which a polycrystal is obtained. The temperature for heating the solidified body is, for example, 700°C or lower.

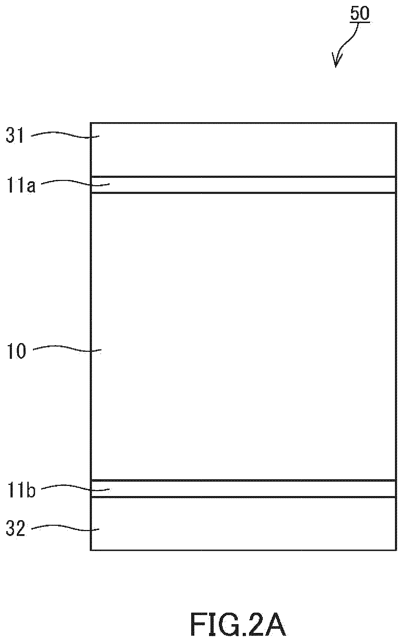

The thermoelectric conversion materials can be used to provide a thermoelectric conversion element. FIG. 2A is a schematic diagram showing an example of a thermoelectric conversion element 50 of the present disclosure. The thermoelectric conversion element 50 includes a thermoelectric conversion body 10, a first electrode 31, and a second electrode 32. The thermoelectric conversion body 10 includes the aforementioned thermoelectric conversion material. The first electrode 31 is electrically connected to one end portion of the thermoelectric conversion body 10. The second electrode 32 is electrically connected to the other end portion of the thermoelectric conversion body 10.

As shown in FIG. 2A, a thermoelectric conversion element 50, for example, includes a first layer 11a and a second layer 11b. The first layer 11a is disposed between the first electrode 31 and the thermoelectric conversion body 10 in its thickness direction. The second layer 11b is disposed between the second electrode 32 and the thermoelectric conversion body 10 in its thickness direction. The first layer 11a is capable of preventing/reducing degradation of thermoelectric conversion performance accompanying a diffusion of a substance present between the first electrode 31 and the thermoelectric conversion body 10. The second layer 11b is capable of preventing/reducing degradation of thermoelectric conversion performance accompanying a diffusion of a substance present between the second electrode 32 and the thermoelectric conversion body 10. The first layer 11a and the second layer 11b each may include Fe, Cu, Mo, W, alloys thereof, or an alloy of SnTe or Al-Si.

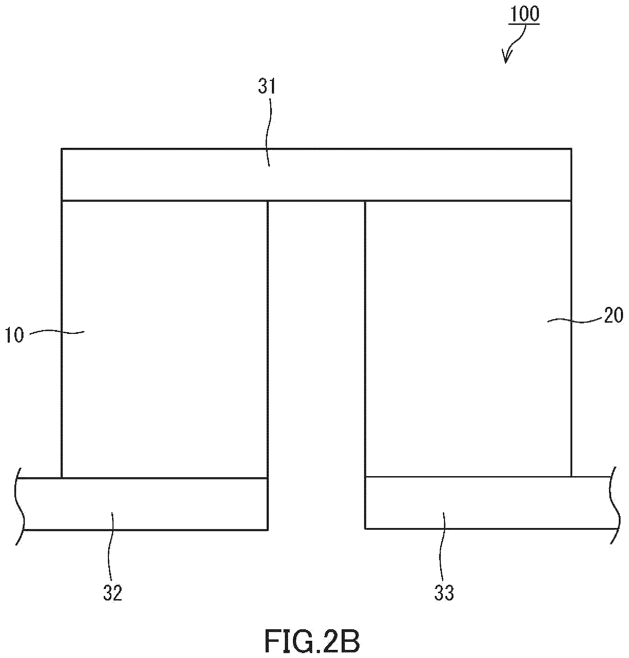

It is possible to provide a thermoelectric conversion module using the aforementioned thermoelectric conversion material. FIG. 2B is a schematic diagram showing an example of a thermoelectric conversion module of the present disclosure. As shown in FIG. 2B, a thermoelectric conversion module 100 includes a p-type thermoelectric conversion body 10, an n-type thermoelectric conversion body 20, a first electrode 31, a second electrode 32, and a third electrode 33. The p-type thermoelectric conversion body 10 includes the aforementioned thermoelectric conversion material. The thermoelectric conversion material included in the n-type thermoelectric conversion body 20 is not limited to any specific material. The n-type thermoelectric conversion body 20 includes, for example, a known n-type thermoelectric conversion material. The first electrode 31 electrically connects one end portion of the p-type thermoelectric conversion body 10 and one end portion of the n-type thermoelectric conversion body 20. The second electrode 32 is electrically connected to the other end portion of the p-type thermoelectric conversion body 10. The third electrode 33 is electrically connected to the other end portion of the n-type thermoelectric conversion body 20.

As shown in FIG. 2A, in the thermoelectric conversion module 100, for example, the first layer 11a is disposed between the first electrode 31 and the p-type thermoelectric conversion body 10, and the second layer 11b is disposed between the second electrode 32 and the p-type thermoelectric conversion body 10.

In the thermoelectric conversion module 100, for example, one end portion of the p-type thermoelectric conversion body 10 and one end portion of the n-type thermoelectric conversion body 20 are located on the same side in a particular direction. For example, when a temperature difference occurs between one end portion and the other end portion of the p-type thermoelectric conversion body 10, a thermoelectromotive force is generated in the p-type thermoelectric conversion body 10. Furthermore, when a temperature difference occurs between one end portion and the other end portion of the n-type thermoelectric conversion body 20, a thermoelectromotive force is generated in the n-type thermoelectric conversion body 20. This allows the thermoelectric conversion module 100 to generate electricity.

By allowing to generate an electric current in the thermoelectric conversion module 100, for example, heat is transferred from one end portion to the other end portion of the p-type thermoelectric conversion body 10, and heat is transferred from one end portion to the other end portion of the n-type thermoelectric conversion body 20. By allowing to generate an electric current in the opposite direction in the thermoelectric conversion module 100, heat is transferred from the other end portion to the one end portion of the p-type thermoelectric conversion body 10, and heat is transferred from the other end portion to the one end portion of the n-type thermoelectric conversion body 20.

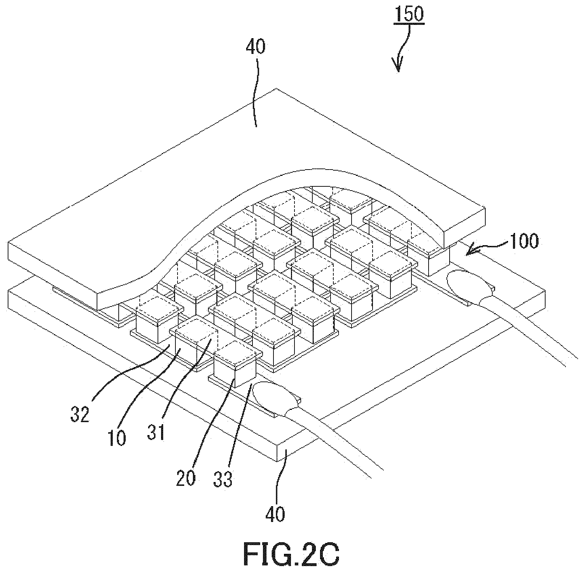

FIG. 2C is a perspective view showing another example of a thermoelectric conversion module of the present disclosure. A thermoelectric conversion module 150 includes a pair of substrates 40 in addition to the thermoelectric conversion module 100. The thermoelectric conversion module 100 is disposed between the pair of substrates 40. One of the pair of substrates 40 is disposed in contact with the first electrode 31, and the other substrate 40 is disposed in contact with the second electrode 32 and the third electrode 33. This configuration reduces temperature variations in the direction parallel to the principal surface of the substrates 40 in the thermoelectric conversion module 150. Materials of the substrates 40 are not limited to any specific material. The substrates 40 include, for example, alumina or aluminum nitride.

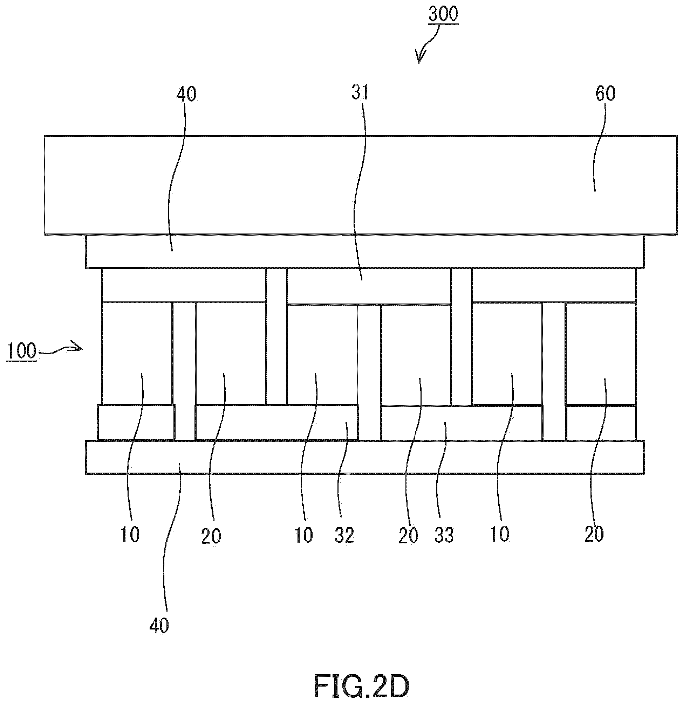

FIG. 2D is a schematic diagram showing an example of a thermoelectric conversion system of the present disclosure. As shown in FIG. 2D, a thermoelectric conversion system 300 includes a thermoelectric conversion module 100 and a heat source 60. The heat source 60 is disposed in the thermoelectric conversion module 100, closer to the first electrode 31 than the second electrode 32 and the third electrode 33. In the thermoelectric conversion system 300, the heat source 60 causes a temperature difference between the both sides of the thermoelectric conversion module 100, and electricity is generated in the thermoelectric conversion module 100.

In the thermoelectric conversion system 300, the heat source 60 may include a heat transfer tube into which a predetermined heating medium is to be led. The heating medium may be a gas such as an exhaust gas or a liquid such as water or oil. The heat source 60 may include a plate for collecting radiant heat.

As shown in FIG. 2D, for example, in the thermoelectric conversion system 300, the thermoelectric conversion module 100 is disposed between a pair of substrates 40. One of the pair of substrates 40 is disposed between the heat source 60 and the thermoelectric conversion module 100.

### EXAMPLES

The present disclosure is explained in detail below with reference to Examples, though the thermoelectric conversion material in the present disclosure is not limited to specific embodiments described below.

### <Example 1>

In a glove box of an argon atmosphere, granular Ge, granular In, granular Ti, granular Sb and granular Te were weighed. The weighing was carried out so that the mole ratio Ge:In:Ti:Sb:Te was 0.86:0.01:0.02:0.07:1. The thus weighed Ge, In, Ti, Sb and Te were introduced into a quartz tube. The quartz tube had an inner diameter of 8 mm and an outer diameter of 10 mm. Next, the interior of the quartz tube was brought into a vacuum state of 3×10⁻² Pa using a turbo molecular pump, and the quartz tube was sealed. This quartz tube was placed inside a table-top electric furnace F-1404P manufactured by Tokyo Garasu Kikai Co., Ltd., and the temperature inside the table-top electric furnace was maintained at 900°C for 12 hours. As a result, Ge, In, Ti, Sb, and Te inside the quartz tube were melted, whereby a melt was obtained. The quartz tube including the liquid-phase melt was then taken out from the table-top electric furnace, the quartz tube was placed in a water tank filled with sufficient water, thereby quenching the melt to obtain a solidified body. With the solidified body inside the quartz tube, the quartz tube was placed again inside the table-top electric furnace, and the temperature inside the table-top electric furnace was maintained at 600°C for 96 hours. In this manner, a composition for a thermoelectric conversion material according to Example 1 was obtained.

Next, the composition for a thermoelectric conversion material according to Example 1 was pulverized on a mortar to obtain a powder according to Example 1. The resulting powder was sintered by a spark plasma sintering (SPS) method to obtain a dense sintered body. The powder (2.0 g) was filled into a cylindrical die made of carbon. The die had an outer diameter of 50 mm and an inner diameter of 10 mm. The powder according to Example 1 was sintered by SPS under conditions of applying a pressure of 60 MPa and heating with electricity for 10 minutes at 550°C, and then gradually reducing the pressure. In this manner, a thermoelectric conversion material according to Example 1 was obtained.

### <Other Examples and Comparative Example 1>

Compositions for thermoelectric conversion material according to Example 2, Example 3, and Comparative Example 1 were prepared in the same manner as Example 1 except that the mole ratio Ge:ln:Ti:Sb:Te was modified as shown in Table 1. Thermoelectric conversion materials according to Example 2, Example 3, and Comparative Example 1 were produced in the same manner as Example 1 except that the respective compositions for thermoelectric conversion materials according to Example 2, Example 3, and Comparative Example 1 were used.

### <Comparative Example 2>

In a glove box of an argon atmosphere, granular Ge, granular In, granular Sb, and granular Te were weighed. The weighing was carried out so that the mole ratio Ge:In:Sb:Te was 0.89:0.01:0.1:1. The thus weighed Ge, In, Sb, and Te were introduced in a BN-made crucible, and a BN-made lid was placed on the crucible. The crucible had an outer diameter of 8 mm. This crucible was disposed inside a stainless steel tube, and the both ends of the stainless steel tube were sealed with stainless steel caps. The stainless steel tube had an inner diameter of 20 mm. Next, this stainless steel tube was placed inside a table-top electric furnace F-1404P manufactured by Tokyo Garasu Kikai Co., Ltd. Ge, In, Sb, and Te inside the crucible were melted by maintaining the temperature inside the table-top furnace at 750°C for 6 hours or more. After that, furnace cooling was performed to obtain a polycrystal according to Comparative Example 2.

Next, the polycrystal according to Comparative Example 2 was taken out from the crucible in the air and pulverized on a mortar to obtain a powder according to Comparative Example 2. The resulting powder was sintered by SPS to obtain a dense sintered body. The powder (2.0 g) was filled into a cylindrical die made of carbon. The die had an outer diameter of 50 mm and an inner diameter of 10 mm. The powder according to Comparative Example 2 was sintered by SPS under conditions of applying a pressure of 60 MPa and heating with electricity for 10 minutes at 550°C. In this manner, a thermoelectric conversion material according to Comparative Example 2 was obtained.

### <Comparative Example 3>

A polycrystal according to Comparative Example 3 was obtained in the same manner as Comparative Example 2 except that granular Ge, granular Ti, granular Sb, and granular Te were weighed so that in the mole ratio Ge:Ti:Sb:Te was 0.89:0.03:0.08:1. A thermoelectric conversion material according to Comparative Example 3 was obtained in the same manner as Comparative Example 2 except that the polycrystal according to Comparative Example 3 was used in place of the polycrystal according to Comparative Example 2.

### [Constitutional analysis of thermoelectric conversion material]

Using a scanning electron microscope SU8220 manufactured by Hitachi High-Technologies, SEM-EDX analysis was performed on specimens prepared from the thermoelectric conversion materials according to the respective Examples and the thermoelectric conversion material according to Comparative Example 1. The constitution of each thermoelectric conversion material was determined by analyzing the intensity of the characteristic X-rays of Ge, In, Ti, Sb, and Te on the surface under evaluation of each specimen observed in this analysis. The results are shown in Table 1. Table 1 shows also (Ge + In + Ti + Sb)/Te, which is the mole ratio of a sum of the contents of Ge, In, Ti, Sb, and Te to the content of Te. Since granular Sb was not used in preparation of the thermoelectric conversion material according to Comparative Example 1, the characteristic X-rays of Sb were not considered in the intensity analysis of characteristic X-rays in the analysis by SEM-EDX. Constitutions of the compositions for thermoelectric conversion materials (solidified bodies) according to the respective Examples and the composition for a thermoelectric conversion material (solidified body) according to Comparative Example 1 were determined in the same way. The results are shown in Table 1.

**[Table 1]**

| | Addition amount of Ge, In, Ti, Sb, and Te | Constitution of composition for thermoelectric conversion material (solidified body) |
|---|---|---|
| Example 1 | Mole ratio Ge:In:Ti:Sb:Te=0.86:0.01:0.02:0.07:1 | Ge_{0.81}In_{0.011}Ti_{0.012}Sb_{0.102}Te₁ |
| Example 2 | Mole ratio Ge:In:Ti:Sb:Te=0.84:0.01:0.02:0.09:1 | Ge_{0.73}In_{0.016}Ti_{0.015}Sb_{0.114}Te₁ |
| Example 3 | Mole ratio Ge:In:Ti:Sb:Te=0.79:0.01:0.02:0.12:1 | Ge_{0.71}In_{0.009}Ti_{0.011}Sb_{0.152}Te₁ |
| Comparative Example 1 | Mole ratio Ge:In:Ti:Sb:Te=0.97:0.01:0.02:0:1 | Ge_{0.99}In_{0.021}Ti_{0.059}Te₁ |
| Comparative Example 2 | Mole ratio Ge:In:Ti:Sb:Te=0.89:0.01:0:0.1:1 | Ge_{0.91}In_{0.017}Sb_{0.140}Te₁ |
| Comparative Example 3 | Mole ratio Ge:In:Ti:Sb:Te=0.89:0:0.03:0.08:1 | Ge_{0.89}Ti_{0.019}Sb_{0.112}Te₁ |

**[Table 1] (continued)**

| | Constitution of thermoelectric conversion material | | Mole ratio (Ge+ln+Ti+Sb)/Te |
|---|---|---|---|
| Example 1 | | Ge_{0.78}In_{0.007}Ti_{0.012}Sb_{0.096}Te₁ | 0.895 |
| Example 2 | | Ge_{0.74}In_{0.017}Ti_{0.011}Sb_{0.112}Te₁ | 0.88 |
| Example 3 | | Ge_{0.69}In_{0.013}Ti_{0.016}Sb_{0.154}Te₁ | 0.873 |
| Comparative Example 1 | | Ge_{0.96}In_{0.013}Ti_{0.01 6}Te₁ | 0.989 |
| Comparative Example 2 | | Ge_{0.94}In_{0.015}Sb_{0.133}Te₁ | 1.088 |
| Comparative Example 3 | | Ge_{0.92}Ti_{0.018}Sb_{0.111}Te₁ | 1.049 |

Using an Agilent 5100 ICP emission spectrometer manufactured by Agilent Technologies, Inc., an ICP emission spectrometry analysis was performed on specimens prepared from the thermoelectric conversion materials according to the respective Examples and a specimen prepared from a thermoelectric conversion material according to Comparative Example 1. Based on the results of this analysis, the constitution of each thermoelectric conversion material was determined. The results are shown in Table 2. Table 2 shows (Ge + In + Ti + Sb)/Te, which is the mole ratio of a sum of the contents of Ge, In, Ti, Sb, and Te to the content of Te. The constitutions of the compositions for thermoelectric conversion materials (solidified bodies) according to the respective Examples and the composition for a thermoelectric conversion material (solidified body) according to Comparative Example 1 were determined in the same way. The results are shown in Table 2.

**[Table 2]**

| | Addition amount of Ge, In, Ti, Sb, and Te | Constitution of composition for thermoelectric conversion material (solidified body) |
|---|---|---|
| Example 1 | Mole ratio Ge:In:Ti:Sb:Te=0.86:0.01:0.02:0.07:1 | Ge_{0.855}In_{0.008}Ti_{0.018}Sb_{0.075}Te₁ |
| Example 2 | Mole ratio Ge:In:Ti:Sb:Te=0.84:0.01:0.02:0.09:1 | Ge_{0.807}In_{0.016}Ti_{0.014}Sb_{0.089}Te₁ |
| Example 3 | Mole ratio Ge:In:Ti:Sb:Te=0.79:0.01:0.02:0.12:1 | Ge_{0.790}In_{0.008}Ti_{0.017}Sb_{0.112}Te₁ |
| Comparative Example 1 | Mole ratio Ge:In:Ti:Sb:Te=0.97:0.01:0.02:0:1 | Ge_{0.964}In_{0.010}Ti_{0.020}Te₁ |
| Comparative Example 2 | Mole ratio Ge:In:Ti:Sb:Te=0.89:0.01:0:0.1:1 | Ge_{0.899}In_{0.010}Sb_{0.104}Te₁ |
| Comparative Example 3 | Mole ratio Ge:In:Ti:Sb:Te=0.89:0:0.03:0.08:1 | Ge_{0.879}Ti_{0.029}Sb_{0.077}Te₁ |

**[Table 2] (continued)**

| | Constitution of thermoelectric conversion material | | Mole ratio (Ge+In+Ti+Sb)/Te |
|---|---|---|---|
| Example 1 | | Ge_{0.859}In_{0.008}Ti_{0.018}Sb_{0.0075}Te₁ | 0.96 |
| Example 2 | | Ge_{0.816}In_{0.01 6}Ti_{0.01 5}Sb_{0.087}Te₁ | 0.934 |
| Example 3 | | Ge_{0.790}In_{0.008}Ti_{0.017}Sb_{0.116}Te₁ | 0.931 |
| Comparative Example 1 | | Ge_{0.966}In_{0.010}Ti_{0.020}Te₁ | 0.997 |
| Comparative Example 2 | | Ge_{0.899}In_{0.010}Sb_{0.104}Te₁ | 1.014 |
| Comparative Example 3 | | Ge_{0.879}Ti_{0.029}Sb_{0.077}Te₁ | 0.986 |

### [Measurement of breaking stress]

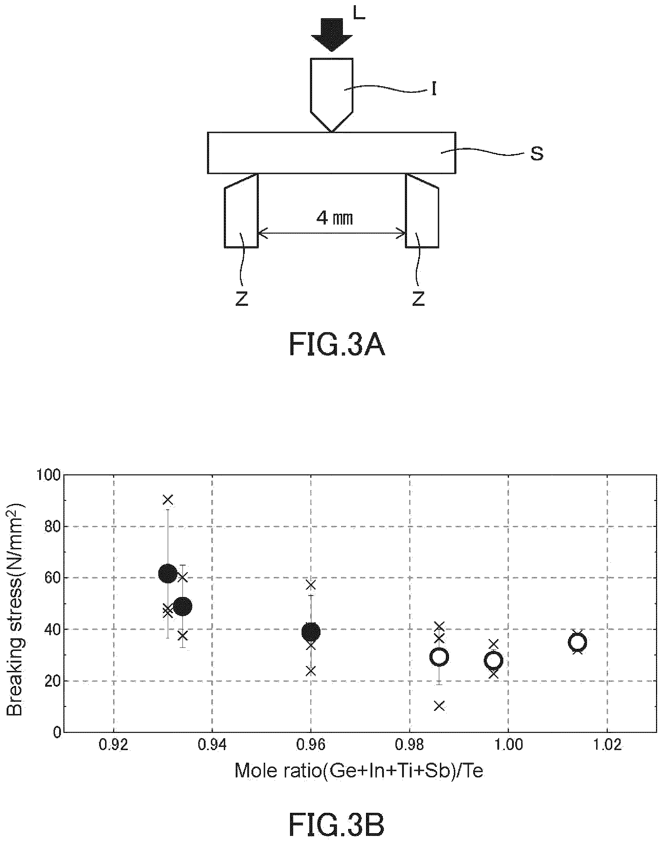

Test pieces S for the three-point bending test were prepared by cutting the thermoelectric conversion material according to each Example and each Comparative Example. A test piece S was a rectangular parallelepiped with a length of 4 mm or more, a thickness of about 2 mm, and a width of about 2 mm. FIG. 3A is a diagram schematically showing a three-point bending test. As shown in FIG. 3A, a test piece S was disposed on a pair of jigs Z with the distance between the fulcrums adjusted to 4 mm, an indenter I was pressed against the test piece S to apply a load L, whereby a three-point bending test was performed in an environment of 25°C. In the three-point bending test, a tester EZ-Test manufactured by Shimadzu Corporation was used, and the test speed was set at 0.5 mm/min. In the three-point bending test, the maximum load [N] recorded just before fracture of the test piece S was considered as the breaking load, and the breaking stress [N/mm²] was calculated by dividing this breaking load by the area of the fracture surface of the test piece. The three-point bending test was performed on two or more test pieces S for the thermoelectric conversion material according to each Example and the thermoelectric conversion material according to each Comparative Example.

FIG. 3B is a graph showing the relationship between the breaking stress of the thermoelectric conversion materials according to the respective Examples and the respective Comparative Examples, and the mole ratio (Ge + In + Ti + Sb)/Te in each thermoelectric conversion material. The mole ratios are based on the results of ICP emission spectroscopy analysis. In FIG. 3B, the black circle plots indicate the average values of the breaking stress of the thermoelectric conversion materials according to the respective Examples. The white circle plots indicate the average values of the breaking stress of the thermoelectric conversion materials according to the respective Comparative Examples.

The comparison between each Example and Comparative Example 1 indicates that, in a case where the thermoelectric conversion material includes In and Te, the breaking stress of the thermoelectric conversion material is likely to be higher when the mole ratio (Ge + In + Ti + Sb)/Te is 0.98 or less. The average value of the breaking stress of the thermoelectric conversion material according to each Example was higher than the average value of the breaking stress of the thermoelectric conversion materials according to Comparative Example 2 (35 N/mm²) and Comparative Example 3 (39 N/mm²).

### [Crystal structure analysis]

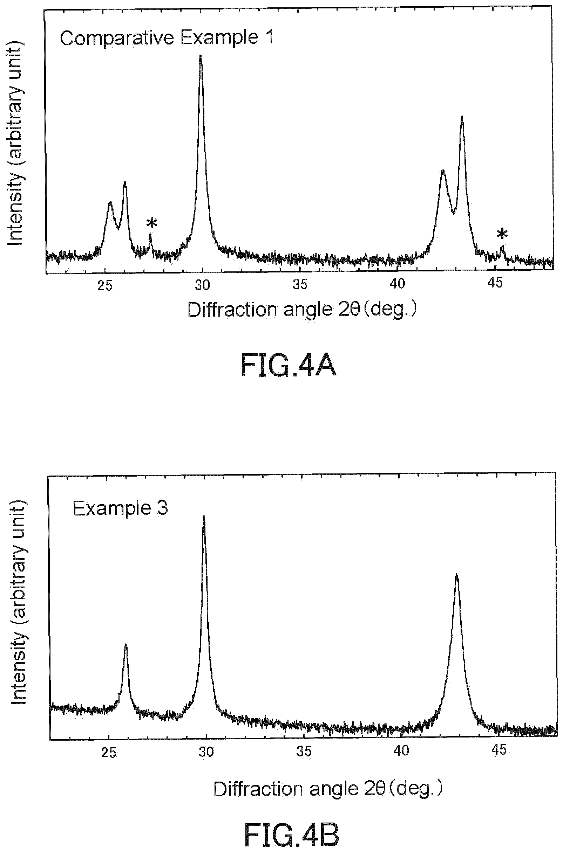

An X-ray diffraction measurement was performed on specimens produced from the thermoelectric conversion materials according to the respective Examples and the respective Comparative Examples, using an X-ray diffractometer Aeris manufactured by Malvern Panalytical. In this measurement, a Cu-Ka ray was used for the X-ray. FIGS. 4A and 4B are graphs showing the results of X-ray diffraction analysis of the thermoelectric conversion materials according to Comparative Example 1 and Example 3, respectively. These results show the measurement results of 2θ-θ scans.

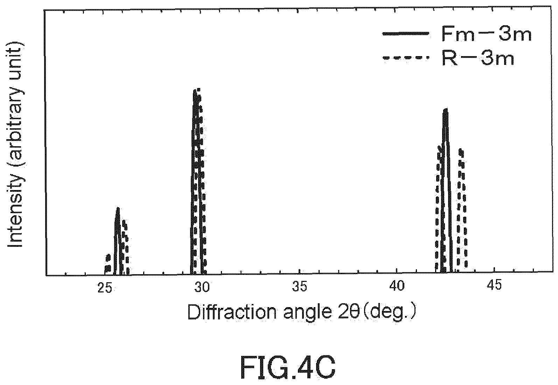

FIG. 4C is a graph showing a simulation result of an X-ray diffraction pattern of GeTe with a cubic crystal structure represented by a space group Fm-3m and an X-ray diffraction pattern of GeTe with a rhombohedral crystal structure represented by a space group R-3m. The lattice constant in these crystal structures is 0.601 nanometers.

As shown in FIG. 4A, in the thermoelectric conversion material according to Comparative Example 1, a diffraction peak derived from a rhombohedron represented by the space group R-3m was confirmed. In addition, as indicated by asterisks in FIG. 4A, diffraction peaks due to a simple substance of Ge in the diamond structure represented by the space group Fd-3m were also observed in the vicinity of 2θ = 27° and in the vicinity of 2θ = 46°. The diffraction peaks were also confirmed in the thermoelectric conversion materials according to Comparative Examples 2 and 3. On the other hand, as shown in FIG. 4B, the diffraction peak of the thermoelectric conversion material according to Example 3 coincides with the diffraction peak of the cubic crystal structure represented by the space group Fm-3m, and no diffraction peaks derived from impurities other than the cubic crystal structure were visually observed. Therefore, it was suggested that in the thermoelectric conversion material according to Example 3, precipitation of a simple substance of Ga was prevented or reduced, and the thermoelectric conversion material was composed of only a cubic crystal structure represented by the space group Fm-3m. This clarified that the toughness of thermoelectric conversion materials can be improved by preventing/reducing a grain boundary segregation of a simple substance of Ge.

### [Performance evaluation of thermoelectric conversion material]

As is well known in the technical field of thermoelectric conversion material, performance of a thermoelectric conversion material is represented by a thermoelectric conversion figure of merit zT. The thermoelectric conversion figure of merit zT is represented as zT = S²σT/κ using Seebeck coefficient S, electrical conductivity σ, thermal conductivity κ, and absolute temperature T. In other words, for high performance of the thermoelectric conversion material, it is advantageous to have a high value of S²σ, which is electrical conduction property, and a low value of thermal conductivity κ. The thermal conductivity κ is a sum of electron thermal conductivity κₑ, which is the component derived from electrons, and lattice thermal conductivity κₗ, which is the component derived from the lattice, and the thermal conductivity is represented as κ = κₑ + κₗ.

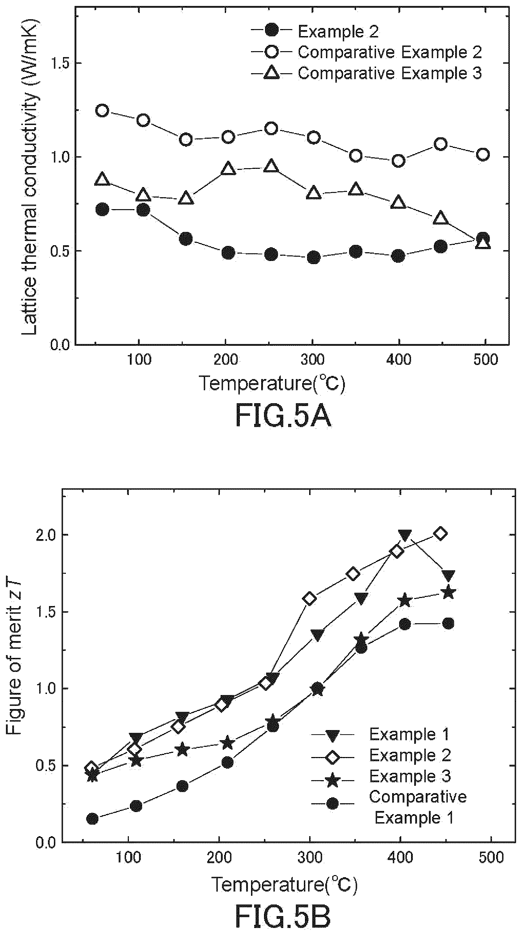

The lattice thermal conductivity κₗ of the thermoelectric conversion material was measured using a table-top laser flash analyzer LFA 457 MicroFlash manufactured by NETZSCH-Geratebau. FIG. 5A is a graph showing the relationship between temperature and lattice thermal conductivity for the thermoelectric conversion materials according to Example 2, Comparative Example 2, and Comparative Example 3. As shown in FIG. 5A, the lattice thermal conductivity of the thermoelectric conversion material according to Example 2 was lower than the lattice thermal conductivities of the thermoelectric conversion materials according to Comparative Examples 2 and 3. This is advantageous in improving the performance of the thermoelectric conversion material. The thermoelectric conversion material according to Example 2 included In, Ti, and Sb. This is considered to be the reason that the anharmonicity of the lattice vibration was increased and the lattice thermal conductivity of the thermoelectric conversion material according to Example 2 was low.

The Seebeck coefficient S and electrical conductivity σ of each thermoelectric conversion material were measured using the thermoelectric property evaluation device ZEM-3 manufactured by Advance Science and Engineering. Based on the measurement results, the thermoelectric conversion figure of merit zT of each thermoelectric conversion material was obtained from the relationship zT = S²σT/κ. FIG. 5B is a graph showing the relationship between temperature and thermoelectric conversion figure of merit zT for the thermoelectric conversion materials according to the respective Examples and Comparative Example 1. As shown in FIG. 5B, the thermoelectric conversion figure of merit zT of the thermoelectric conversion material according to each Example was higher than the thermoelectric conversion figure of merit zT of the thermoelectric conversion material according to Comparative Example 1, and the thermoelectric conversion figure of merit zT of the thermoelectric conversion material according to Example 2 was the highest among them.

It has been suggested that by including not only Ge and Te but also In, Ti, and at least one selected from the group consisting of Sb and Bi in the thermoelectric conversion material, and by adjusting the contents of the respective elements to a predetermined ratio, the thermoelectric conversion material has a desired toughness and desired thermoelectric conversion performance.

### (Appendix)

From the above description, the following techniques are disclosed.

### (Technique 1)

A thermoelectric conversion material including: Ge, In, Ti, at least one selected from the group consisting of Sb and Bi, and Te,
wherein the thermoelectric conversion material satisfies a requirement (1): a + β + γ ≤ 0.98,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

### (Technique 2)

The thermoelectric conversion material according to Technique 1, satisfying a requirement (2): β + γ < a.

### (Technique 3)

The thermoelectric conversion material according to Technique 1 or 2, satisfying a requirement (3): a + β + γ ≥ 0.85.

### (Technique 4)

The thermoelectric conversion material according to any one of Techniques 1 to 3, having a NaCl-type crystal structure.

### (Technique 5)

The thermoelectric conversion material according to Technique 4, wherein in the NaCl-type crystal structure, Ge, In, Ti, Sb, and Bi are each arranged at a Na site and Te is arranged at a Cl site.

### (Technique 6)

The thermoelectric conversion material according to Technique 4 or 5,
wherein the thermoelectric conversion material is a polycrystal comprising a plurality of crystal grains, and
each of the crystal grains has a NaCl-type crystal structure.

### (Technique 7)

The thermoelectric conversion material according to any one of Techniques 1 to 6, wherein the thermoelectric conversion material has a crystal structure belonging to at least one selected from the group consisting of a space group Fm-3m and a space group R-3m.

### (Technique 8)

The thermoelectric conversion material according to any one of Techniques 1 to 7, having a constitution represented by Ge_{α}InₓTi_{β-x}Sb_{y}Bi_{γ-y}Te, and satisfying requirements 0.65 ≤ α < 0.98, 0 < β ≤ 0.1, 0 < x < β, 0 < γ ≤ 0.2, and 0 ≤ y ≤ γ for the constitution.

### (Technique 9)

The thermoelectric conversion material according to Technique 8, satisfying a requirement 0.04 < γ ≤ 0.16 for the constitution.

### (Technique 10)

The thermoelectric conversion material according to Technique 8 or 9, satisfying a requirement 0.001 ≤ β ≤ 0.04 for the constitution.

### (Technique 11)

The thermoelectric conversion material according to any one of Techniques 1 to 10, wherein the thermoelectric conversion material satisfies a requirement (4): 30 N/mm² ≤ BS ≤ 5000 N/mm², where BS indicates a breaking stress of the thermoelectric conversion material.

### (Technique 12)

A composition for a thermoelectric conversion material, the composition comprising Ge, In, Ti, at least one selected from the group consisting of Sb and Bi, and Te, the composition satisfying a requirement (5): a + β + γ ≤ 1.0,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

### (Technique 13)

A thermoelectric conversion element including:
a thermoelectric conversion body;
a first electrode electrically connected to one end portion of the thermoelectric conversion body; and
a second electrode electrically connected to the other end portion of the thermoelectric conversion body,
wherein the thermoelectric conversion body includes the thermoelectric conversion material according to any one of Techniques 1 to 11.

### (Technique 14)

A thermoelectric conversion module including:
a p-type thermoelectric conversion body;
an n-type thermoelectric conversion body;
a first electrode electrically connecting one end portion of the p-type thermoelectric conversion body and one end portion of the n-type thermoelectric conversion body;
a second electrode electrically connected to the other end portion of the p-type thermoelectric conversion body; and
a third electrode electrically connected to the other end portion of the n-type thermoelectric conversion body,
wherein the p-type thermoelectric conversion body includes the thermoelectric conversion material according to any one of Techniques 1 to 11.

### (Technique 15)

A thermoelectric conversion system including:
the thermoelectric conversion module according to Technique 14; and
a heat source disposed closer to the first electrode than the second and third electrodes.

### (Technique 16)

A method of manufacturing a composition for a thermoelectric conversion material, the method including:
heating a mixture comprising Ge, In, Ti, at least one selected from the group consisting of Sb and Bi, and Te at a temperature of 700°C or higher to obtain a melt;
quenching the melt with a liquid having a temperature of 100°C or lower to obtain a solidified body; and
heating the solidified body at 400°C or higher to obtain a polycrystal,

wherein the composition for a thermoelectric conversion material satisfies a requirement (6): a + β + γ ≤ 1.0,
where a is a molar ratio of a content of Ge to a content of Te,

β is a molar ratio of a sum of a content of In and a content of Ti to the content of Te, and
γ is a molar ratio of a sum of a content Sb and a content of Bi to the content of Te.

### (Technique 17)

A method of manufacturing a thermoelectric conversion material, including:
energizing an alloy powder comprising Ge, In, Ti, at least one selected from the group consisting of Sb and Bi, and Te by a spark plasma sintering method to sinter the alloy powder at a temperature of 500°C or higher,
wherein the thermoelectric conversion material satisfies a requirement (7): a + β + γ ≤ 0.98,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

### INDUSTRIAL APPLICABILITY

The thermoelectric conversion material of the present disclosure can be used for a thermoelectric conversion element capable of converting thermal energy into electrical energy.

## Claims

1. A thermoelectric conversion material comprising: Ge, In, Ti, at least one selected from the group consisting of Sb and Bi, and Te,
wherein the thermoelectric conversion material satisfies a requirement (1): a + β + γ ≤ 0.98,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

2. The thermoelectric conversion material according to claim 1, satisfying a requirement (2): β + γ < a.

3. The thermoelectric conversion material according to claim 1, satisfying a requirement (3): a + β + γ ≥ 0.85.

4. The thermoelectric conversion material according to claim 1, having a NaCl-type crystal structure.

5. The thermoelectric conversion material according to claim 4, wherein in the NaCl-type crystal structure, Ge, In, Ti, Sb, and Bi are each arranged at a Na site and Te is arranged at a Cl site.

6. The thermoelectric conversion material according to claim 4,
wherein the thermoelectric conversion material is a polycrystal comprising a plurality of crystal grains, and
each of the crystal grains has a NaCl-type crystal structure.

7. The thermoelectric conversion material according to claim 1, wherein the thermoelectric conversion material has a crystal structure belonging to at least one selected from the group consisting of a space group Fm-3m and a space group R-3m.

8. The thermoelectric conversion material according to claim 1, having a constitution represented by Ge_{α}InₓTi_{β-x}Sb_{y}Bi_{γ-y}Te, and satisfying requirements 0.65 ≤ a < 0.98, 0 < β ≤ 0.1, 0 < x < β, 0 < γ ≤ 0.2, and 0 ≤ y ≤ γ for the constitution.

9. The thermoelectric conversion material according to claim 8, satisfying a requirement 0.04 < γ ≤ 0.16 for the constitution.

10. The thermoelectric conversion material according to claim 8, satisfying a requirement 0.001 ≤ β ≤ 0.04 for the constitution.

11. The thermoelectric conversion material according to claim 1, wherein the thermoelectric conversion material satisfies a requirement (4): 30 N/mm² ≤ BS ≤ 5000 N/mm²,
where BS indicates a breaking stress of the thermoelectric conversion material.

12. A composition for a thermoelectric conversion material, the composition comprising Ge, In, Ti, at least one selected from the group consisting of Sb and Bi, and Te, the composition satisfying a requirement (5): a + β + γ ≤ 1.0,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.

13. A thermoelectric conversion element comprising:
a thermoelectric conversion body;
a first electrode electrically connected to one end portion of the thermoelectric conversion body; and
a second electrode electrically connected to the other end portion of the thermoelectric conversion body,
wherein the thermoelectric conversion body comprises the thermoelectric conversion material according to any one of claims 1 to 11.

14. A thermoelectric conversion module comprising:
a p-type thermoelectric conversion body;
an n-type thermoelectric conversion body;
a first electrode electrically connecting one end portion of the p-type thermoelectric conversion body and one end portion of the n-type thermoelectric conversion body;
a second electrode electrically connected to the other end portion of the p-type thermoelectric conversion body; and
a third electrode electrically connected to the other end portion of the n-type thermoelectric conversion body,
wherein the p-type thermoelectric conversion body comprises the thermoelectric conversion material according to any one of claims 1 to 11.

15. A thermoelectric conversion system comprising:
the thermoelectric conversion module according to claim 14; and
a heat source disposed closer to the first electrode than the second and third electrodes.

16. A method of manufacturing a composition for a thermoelectric conversion material, the method comprising:
heating a mixture comprising Ge, In, Ti, at least one selected from the group consisting of Sb and Bi, and Te at a temperature of 700°C or higher to obtain a melt;
quenching the melt with a liquid having a temperature of 100°C or lower to obtain a solidified body; and
heating the solidified body at 400°C or higher to obtain a polycrystal,
wherein the composition for a thermoelectric conversion material satisfies a requirement (6): a + β + γ ≤ 1.0,
where a is a molar ratio of a content of Ge to a content of Te,
β is a molar ratio of a sum of a content of In and a content of Ti to the content of Te, and
γ is a molar ratio of a sum of a content Sb and a content of Bi to the content of Te.

17. A method of manufacturing a thermoelectric conversion material, comprising:
energizing an alloy powder comprising Ge, In, Ti, at least one selected from the group consisting of Sb and Bi, and Te by a spark plasma sintering method to sinter the alloy powder at a temperature of 500°C or higher,
wherein the thermoelectric conversion material satisfies a requirement (7): a + β + γ ≤0.98,
where a is a molar ratio of a content of Ge to a content of Te,
β is a molar ratio of a sum of a content of In and a content of Ti to the content of Te, and
γ is a molar ratio of a sum of a content of Sb and a content of Bi to the content of Te.
